# EUROPEAN PATENT APPLICATION

(11) **EP 4 455 702 A1**
(43) Date of publication of application: **30.10.2024**
(21) Application number: 22924057.7
(22) Date of filing: 17.11.2022
(51) Int. Cl.: G01R 31/392, B60L 55/00, B60L 58/10, G01R 31/367, G16Y 10/40, G16Y 20/20, G16Y 40/20, H01M 10/48, H02J 7/00

(54) **INFORMATION PROCESSING METHOD, INFORMATION PROCESSING DEVICE, AND CONTROL PROGRAM**

(30) Priority: 25.01.2022 JP 2022009061
(71) Applicant: Panasonic Intellectual Property Corporation of America, Torrance, CA 90504 (US)
(72) Inventor: IMOTO, Junichi, Kadoma-shi, Osaka 571-0057 (JP)
(74) Representative: Grünecker Patent- und Rechtsanwälte PartG mbB
(86) International application number: PCT/JP2022/042668
(87) International publication number: WO 2023/145205

(57) **Abstract**

A server 2 acquires log data indicative of a state history of a chargeable and dischargeable battery 151 and information indicative of a plurality of use fields of the battery 151 associated with the log data; extracts specific log data associated with each of the use fields from the log data; estimates a degradation degree of the battery 151 caused by use of the battery 151 in each of the use fields on the basis of the specific log data associated with each of the use fields; and outputs each of the use fields and the degradation degree of the battery 151 associated with each of the use fields.

## Description

### Technical Field

The present disclosure relates to a technique of outputting a degradation degree of a chargeable and dischargeable battery.

### Background Art

In recent years, a technique of using a chargeable and dischargeable battery such as a lithium-ion battery in a plurality of use fields has received attention. For example, Patent Literature 1 discloses that a degraded secondary battery that was installed in a vehicle but is no longer usable as a power source of the vehicle is sold to be used as a stationary battery for a house, and also discloses displaying a degradation degree of the secondary battery during use of the secondary battery in the vehicle or in the house.

However, in the conventional technique described above, it is impossible to recognize respective degrees of degradation of a secondary battery in use fields during a period in which the secondary battery is used in the use fields.

### Citation List

### Patent Literature

Patent Literature 1: Japanese Unexamined Patent Publication No. 2021-40366

### Summary of Invention

The present disclosure has been made to solve the above-mentioned problems, and an object thereof is to provide a technique that enables recognition of respective degrees of degradation of a chargeable and dischargeable battery in use fields during a period in which the battery is used in the use fields.

An information processing method according to an aspect of the present disclosure for outputting a degradation degree of a chargeable and dischargeable battery, by a computer, includes: acquiring log data indicative of a state history of the battery and information indicative of a plurality of use fields of the battery associated with the log data; extracting specific log data associated with each of the use fields from the log data; estimating a degradation degree of the battery caused by use of the battery in each of the use fields on the basis of the specific log data associated with each of the use fields; and outputting each of the use fields and the degradation degree of the battery associated with each of the use fields.

### Brief Description of Drawings

FIG. 1 is a diagram showing a whole configuration of an information processing system according to an embodiment of the present disclosure.
FIG. 2 is a diagram showing an exemplary configuration of a vehicle.
FIG. 3 is a diagram showing an exemplary configuration of a server.
FIG. 4 is a table showing exemplary log data and use field information stored in a log storage part.
FIG. 5 is a diagram showing an exemplary configuration of a user terminal.
FIG. 6 is an illustration showing an exemplary degradation degree in each use field as an output.
FIG. 7 is a flowchart showing steps of an exemplary degradation degree estimation process.
FIG. 8 is a flowchart showing steps of an exemplary degradation degree output process.
FIG. 9 is an illustration showing an exemplary breakdown of a degradation degree of a battery associated with use in the vehicle as an output.
FIG. 10 is an illustration showing an exemplary breakdown of a degradation degree of the battery associated with use with a charge and discharge device as an output.
FIG. 11 is an illustration showing exemplary information on states of the battery during discharge and charge as an output.
FIG. 12 is an illustration showing an exemplary DOD histogram as an output.

### Description of Embodiments

### Underlying Findings for Present Disclosure

In recent years, a technique of using a chargeable and dischargeable battery in a plurality of use fields, e.g., Vehicle to X (V2X) that involves using a chargeable and dischargeable battery installed in a vehicle also as a power source to supply electricity outside the vehicle, has received attention. However, in the conventional technique described above, the battery is not supposed to be used in a plurality of use fields during a specific period, and only a degradation degree of the battery associated with the current use field is displayed. Therefore, it is impossible to recognize respective degrees of degradation of a battery in a plurality of use fields during a period in which the battery is used in the use fields.

For example, in a case where a chargeable and dischargeable battery installed in a vehicle is not only used during running of the vehicle but also used as a power source for an electric device outside the vehicle during stopping of the vehicle, it is impossible in the conventional technique described above to recognize each of a degree of degradation due to use of the battery during running of the vehicle and a degree of degradation due to use of the battery as the power source for the electric device outside the vehicle. Therefore, a vehicle manufacturer cannot provide a guarantee about a battery installed in a vehicle, e.g., a guarantee that "the degradation degree of the battery will be Y % or less for a travel distance of X kilometers".
(1) To solve the above-mentioned problems, an information processing method according to an aspect of the present disclosure for outputting a degradation degree of a chargeable and dischargeable battery, by a computer, includes: acquiring log data indicative of a state history of the battery and information indicative of a plurality of use fields of the battery associated with the log data; extracting specific log data associated with each of the use fields from the log data; estimating a degradation degree of the battery caused by use of the battery in each of the use fields on the basis of the specific log data associated with each of the use fields; and outputting each of the use fields and the degradation degree of the battery associated with each of the use fields.

In this configuration, each of use fields of a chargeable and dischargeable battery and a degradation degree of the battery associated with each of the use fields are output. Thus, respective degrees of degradation of the battery in use fields can be recognized.

(2) In the information processing method described in (1) above, in the estimation, the degradation degree of the battery caused by the use of the battery in each of the use fields may be estimated by inputting the specific log data to a trained model that has learned a relationship between the state history of the battery and the degradation degree of the battery.

This configuration enables accurate estimation of the degradation degree of the battery caused by the use of the battery in each of the use fields.

(3) In the information processing method described in (1) or (2) above, the battery may be installed in a vehicle and may be chargeable and dischargeable by a charge and discharge device outside the vehicle, and the use fields may include use in the vehicle and use with the charge and discharge device.

In this configuration, respective degradation degrees of the battery caused by the use of the battery in the vehicle and the use of the battery with the charge and discharge device are output. Therefore, this configuration enables recognition of respective degrees of degradation of the battery in a case where the battery is used in the vehicle and a case where the battery is used with the charge and discharge device.

(4) In the information processing method described in (3) above, the use in the vehicle may be classified into use during running of the vehicle and use during stopping of the vehicle, and the information processing method may further include outputting respective ratios of degradation degrees of the battery associated with the use during running of the vehicle and the use during stopping of the vehicle to the degradation degree of the battery associated with the use in the vehicle.

In this configuration, respective ratios of degradation degrees of the battery associated with the use during running of the vehicle and the use during stopping of the vehicle to the degradation degree of the battery associated with the use in the vehicle are output. Thus, a comparison of the output ratios enables recognition of which of the uses of the battery during running and stopping of the vehicle has promoted the degradation of the battery.

(5) In the information processing method described in (3) above, the use with the charge and discharge device may be classified into charging use and discharging use, and the information processing method may further include outputting respective ratios of degradation degrees of the battery associated with the charging use and the discharging use to the degradation degree of the battery associated with the use with the charge and discharge device.

In this configuration, respective ratios of degradation degrees of the battery associated with the charging use and the discharging use to the degradation degree of the battery associated with the use with the charge and discharge device are output. Thus, a comparison of the output ratios enables recognition of which of the uses of the battery during charge and discharge with the charge and discharge device has promoted the degradation of the battery.

(6) The information processing method described in any one of (3) to (5) above may further include: acquiring at least one of first information on a state of the battery during discharge and second information on a state of the battery during charge from the specific log data; and outputting the at least one information.

In this configuration, at least one information of the first information and the second information acquired from the specific log data is output. Thus, at least one of states of the battery during discharge and charge while the battery is used in each of the use fields can be recognized.

(7) In the information processing method described in (6) above, the first information may include a histogram indicative of a relationship between a discharge rate indicative of a discharge amount per a unit time from the battery and a total time during which the battery is discharged at the discharge rate, and the second information may include a histogram indicative of a relationship between a charge rate indicative of a charge amount per a unit time for the battery and a total time during which the battery is charged at the charge rate.

This configuration enables recognition of at least one relationship of a relationship between a discharge rate and a total time during which the battery is discharged at the discharge rate and a relationship between a charge rate and a total time during which the battery is charged at the charge rate.

(8) The information processing method described in any one of (3) to (7) above may further include outputting a histogram indicative of a relationship between a depth of discharge in a discharge of the battery immediately before a start of a charge of the battery and a number of times of chargings of the battery having the depth of discharge on the basis of the specific log data.

This configuration enables recognition of a relationship for the use of the battery in each of the use fields between a depth of discharge in a discharge of the battery immediately before a start of a charge of the battery and a number of times of chargings of the battery having the depth of discharge.

(9) In the information processing method described in any one of (1) to (8) above, the degradation degree of the battery may be a variation from an initial value of an SOH of the battery.

In this configuration, a variation from an initial value of an SOH of the battery is output as the degradation degree of the battery associated with each of the use fields. Thus, a change of the SOH of the battery from the initial value due to the use of the battery in each of the use fields can be recognized.

(10) An information processing apparatus according to another aspect of the present disclosure for outputting a degradation degree of a chargeable and dischargeable battery includes: an acquisition part for acquiring log data indicative of a state history of the battery and information indicative of a plurality of use fields of the battery associated with the log data; an extraction part for extracting specific log data associated with each of the use fields from the log data; an estimation part for estimating a degradation degree of the battery caused by use of the battery in each of the use fields on the basis of the specific log data associated with each of the use fields; and an output part for outputting each of the use fields and the degradation degree of the battery associated with each of the use fields.

This configuration exerts the same advantageous effects as those described for the information processing method described in (1) above.

(11) A control program according to another aspect of the present disclosure for an information processing apparatus for outputting a degradation degree of a chargeable and dischargeable battery, the control program causing a computer included in the information processing apparatus to serve as: an acquisition part for acquiring log data indicative of a state history of the battery and information indicative of a plurality of use fields of the battery associated with the log data; an extraction part for extracting specific log data associated with each of the use fields from the log data; an estimation part for estimating a degradation degree of the battery caused by use of the battery in each of the use fields on the basis of the specific log data associated with each of the use fields; and an output part for outputting each of the use fields and the degradation degree of the battery associated with each of the use fields.

This configuration exerts the same advantageous effects as those described for the information processing method described in (1) above.

Embodiments of the present disclosure will be described below with reference to the attached drawings. The following embodiments are merely examples realized from the present disclosure and the technical scope of the present disclosure is not limited thereto.

### Embodiments

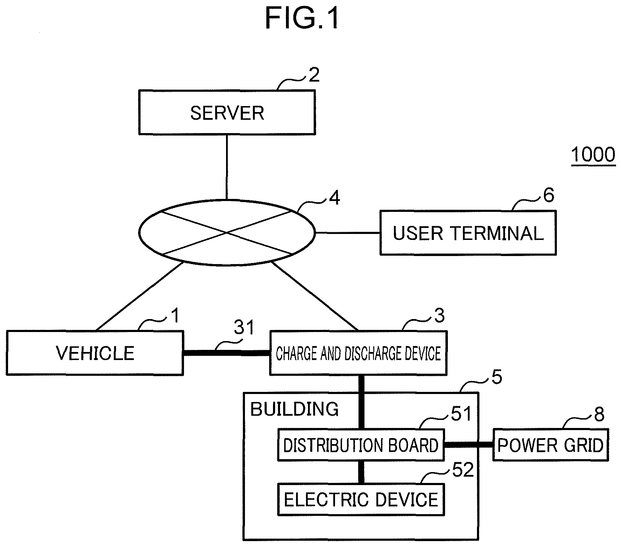

FIG. 1 is a diagram showing a whole configuration of an information processing system 1000 according to an embodiment of the present disclosure. The information processing system 1000 includes a vehicle 1, a server 2 (an information processing apparatus), a charge and discharge device 3, and a user terminal 6.

The vehicle 1 is an electric vehicle that has a chargeable and dischargeable battery and moves by supply of power charged in the battery to an electric motor, e.g., an electric automobile, an electric truck, an electric motorcycle, or an electric bicycle. The information processing system 1000 may include an electric mobile body that has a chargeable and dischargeable battery and moves by power charged in the battery, e.g., a drone, a vessel, and a robot.

The vehicle 1 and the server 2 are communicably connected with each other via a network 4. The network 4 includes, e.g., the Internet. The vehicle 1 periodically transmits log data indicative of a state of a battery installed in the vehicle 1 to the server 2. The details of the log data will be described later.

The server 2 is, e.g., a cloud server. The server 2 is connected and mutually communicable with the vehicle 1, the charge and discharge device 3, and the user terminal 6 via the network 4. The server 2 receives various kinds of information such as log data from the vehicle 1 and the charge and discharge device 3. The server 2 estimates a degradation degree of the battery installed in the vehicle 1 in each of use fields of the battery on the basis of the log data received from the vehicle 1 and the charge and discharge device 3 in response to a request from the user terminal 6, and sends back information indicative of a result of the estimation to the user terminal 6.

The charge and discharge device 3 is outside the vehicle 1 and electrically connected with a distribution board 51 of a building 5. The building 5 is a building owned by a user under a contract for use of power supplied from a power grid 8. The building 5 includes, e.g., an office and a factory owned by the user, and a house where the user lives. The charge and discharge device 3 is electrically connected with one end of a charging cable 31. The other end of the charging cable 31 is to be electrically connected with the battery installed in the vehicle 1.

The charge and discharge device 3 charges a battery installed in the vehicle 1 by supplying power distributed by the distribution board 51 to the battery through the charging cable 31. The charge and discharge device 3 also causes discharge of power charged in the battery to an electric device 52 electrically connected with the distribution board 51 through the charging cable 31 and the distribution board 51.

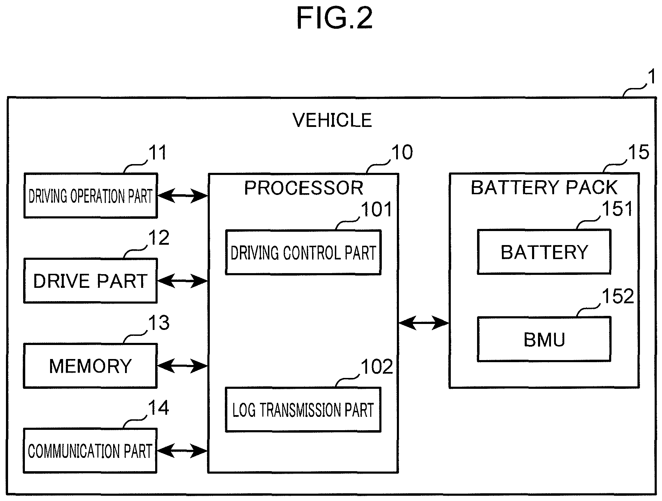

The charge and discharge device 3 contains an unillustrated communication circuit for communication with an external device through the network 4. The charge and discharge device 3 transmits the log data indicative of states of the battery during charge and discharge to the server 2 by using the communication circuit. The vehicle 1 may have a function of the charge and discharge device 3. The server 2 may remotely control the charge and the discharge of a battery 151 (FIG. 2) by the charge and discharge device 3 through the network 4.

The user terminal 6 is an information processing terminal owned by a user of the information processing system 1000, e.g., a smartphone, a tablet device, and/or a laptop computer. The user terminal 6 communicates various kinds of information with an external device, e.g., the vehicle 1, the charge and discharge device 3, or the server 2 through the network 4. The user terminal 6 includes a touchscreen device and a display device such as a liquid crystal display. The user terminal 6 causes the display device to display information received from the external device and a certain operation screen. The user terminal 6 transmits to the external device information that the user has input to the operation screen by using the touchscreen device.

FIG. 2 is a diagram showing an exemplary configuration of the vehicle 1. The vehicle 1 includes a driving operation part 11, a drive part 12, a memory 13, a communication part 14, a battery pack 15, and a processor 10.

The driving operation part 11 accepts a driving operation to the vehicle 1 by a driver. The driving operation part 11 includes, e.g., a steering wheel, a shifter, an accelerator pedal, and a brake pedal. In a case where the vehicle 1 is a self-driving car, a self-driving system substitutes for the driving operation part 11 and controls the driving.

The drive part 12 includes, e.g., an inverter, an electric motor, and a transmission, and causes the vehicle 1 to move under control by a driving control part 101.

The memory 13 is a storage device capable of storing various kinds of information, e.g., a random access memory (RAM), a solid state drive (SSD), or a flash memory.

The communication part 14 is a communication interface circuit that transmits and receives various kinds of information to and from an external device such as the server 2 through the network 4.

The battery pack 15 includes the battery 151 and a battery management unit (BMU) 152.

The battery 151 is a secondary battery that is chargeable and dischargeable, e.g., a lithium-ion battery. The battery 151 is charged with power converted from regenerative energy in the drive part 12 or power supplied from the charge and discharge device 3 through the charging cable 31. The power charged in the battery 151 is used in the drive part 12. The power charged in the battery 151 is discharged to the electric device 52 by the charge and discharge device 3 through the charging cable 31 and the distribution board 51.

The BMU 152 is, for example, a microcomputer including, e.g., a processor, a random access memory (RAM), a non-volatile memory such as a read only memory (ROM), an input-output circuit, a timer circuit, and various measurement circuits. The various measurement circuits include respective measurement circuits for measuring a current, a voltage, and a temperature of the battery 151.

The BMU 152 measures the state of the battery 151 periodically, e.g., every 10 seconds, and stores log data indicative of a result of the measurement in the non-volatile memory in the BMU 152. The log data includes, e.g., identification information of the battery 151 (hereinafter, battery ID), a time of measurement of the state of the battery 151 (hereinafter, measurement time), and information indicative of a result of the measurement of the state of the battery 151 (hereinafter, state information).

The state of the battery 151 covers the current, the voltage, the temperature, and a state of charge (SOC) of the battery 151. The SOC is an index indicative of a level of charge of the battery 151. The SOC of the battery 151 is represented by: (Remaining Capacity (Ah) / Full Charge Capacity (Ah)) * 100. The state of the battery 151 is not limited to these.

The BMU 152 estimates a state of health (SOH) of the battery 151 at a certain time on the basis of the log data stored in the non-volatile memory in the BMU 152. The BMU 152 stores the estimated SOH and a current date and time in the non-volatile memory in the BMU 152 in association with each other. The SOH is an index indicative of a health of the battery 151. The SOH of the battery 151 is represented by: (Degraded (Current) Full Charge Capacity (Ah) / Initial Full Charge Capacity (Ah)) * 100.

The BMU 152 estimates the SOH of the battery 151, for example, at a time of completion of a charge of the battery 151 on the basis of log data stored in the non-volatile memory during the charge. In this regard, the BMU 152 may estimate the SOH of the battery 151 at another time on the basis of log data stored in the non-volatile memory.

The processor 10 includes, for example, a central processing unit (CPU). An execution of a control program stored in the memory 13 causes the processor 10 to function as the driving control part 101 and a log transmission part 102.

The driving control part 101 causes the vehicle 1 to move by controlling the drive part 12 according to a driving operation by the driver through the driving operation part 11.

For example, the driving control part 101 causes the battery 151 to supply the power thereof to the drive part 12 to cause the electric motor to rotate when an operation of depressing the accelerator pedal (hereinafter, accelerator operation) is performed. Thus, the power of the battery 151 is discharged to the electric motor. The driving control part 101 causes the drive part 12 to reduce a rotation speed of the electric motor when an operation of depressing the brake pedal (hereinafter, brake operation) is performed. The drive part 12 converts regenerative energy produced in the electric motor by this operation into power, and supplies the power to the battery 151. Thus, the battery 151 is charged with the power.

The log transmission part 102 periodically acquires log data stored in the non-volatile memory in the BMU 152, and transmits the log data and information (hereinafter, use field information) indicative of a use field of the battery 151 at a measurement time included in the log data to the server 2 through the communication part 14. The use field information includes information (hereinafter, type information) indicative of a type of a use field of the battery 151 and information (hereinafter, detail information) indicative of a detail of the use field of the battery 151.

For example, in a case where the log transmission part 102 transmits log data acquired during the accelerator operation and the brake operation to the server 2, the log transmission part 102 transmits use field information including: information "EV" (hereinafter, vehicle use information) indicating that the use of the battery 151 is use in the vehicle 1 as the type information; and information "Run" (hereinafter, running use information) indicating that the use of the battery 151 is use during running of the vehicle 1 as the detail information.

In a case where the log transmission part 102 transmits log data acquired during stopping of the vehicle 1 to the server 2, the log transmission part 102 transmits use field information including: the vehicle use information "EV" as the type information; and information "Stop" (hereinafter, stopping use information) indicating that the use of the battery 151 is use during stopping of the vehicle 1 as the detail information. The stopping of the vehicle 1 indicates, e.g., a parking state of the vehicle 1, i.e., a time when the power of the battery 151 is not used.

Similarly to the log transmission part 102, the charge and discharge device 3 periodically acquires log data stored in the non-volatile memory in the BMU 152 during the charge and the discharge of the battery 151 through the charging cable 31, and transmits the log data and the use field information associated with the log data to the server 2.

Specifically, in a case where the charge and discharge device 3 transmits log data during a charge of the battery 151 to the server 2, the charge and discharge device 3 transmits use field information including: information "EM" (hereinafter, external use information) indicating that the use of the battery 151 is use with the charge and discharge device 3 as the type information; and information "Charge" (hereinafter, charging use information) indicating that the use of the battery 151 is charging use as the detail information.

On the other hand, in a case where the charge and discharge device 3 transmits log data to the server 2 while causing the battery 151 to discharge the power charged therein to the electric device 52, the charge and discharge device 3 transmits use field information including: the external use information "EM" as the type information; and information (hereinafter, discharging use information) indicating that the use of the battery 151 is discharging use as the detail information.

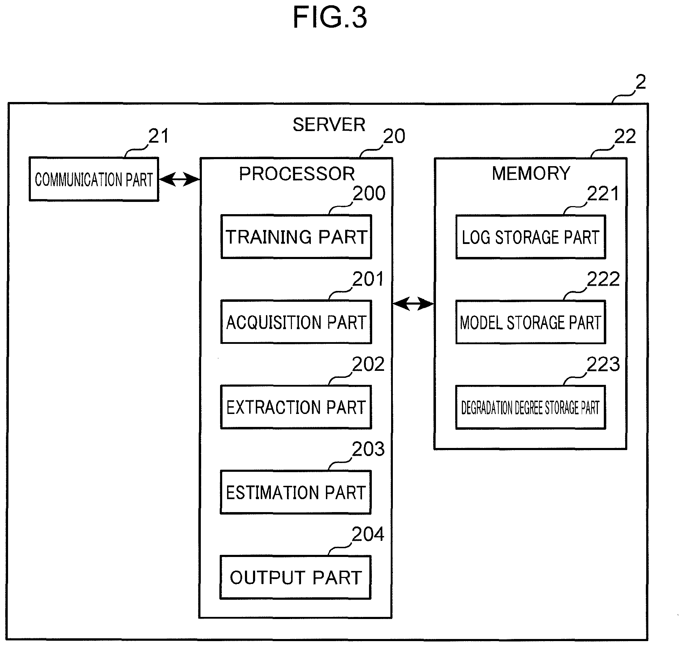

FIG. 3 is a diagram showing an exemplary configuration of the server 2. The server 2 includes a communication part 21, a memory 22, and a processor 20 (a computer).

The communication part 21 is a communication interface circuit that transmits and receives various kinds of information to and from an external device such as the vehicle 1, the charge and discharge device 3, and the user terminal 6 through the network 4. For example, when receiving log data from the vehicle 1 and the charge and discharge device 3, the communication part 21 outputs the received log data to the processor 20. The communication part 21 transmits information indicative of a result of the estimation of the degradation degree of the battery 151 in each of the use fields to the user terminal 6 under control by the processor 20.

The memory 22 is a storage device capable of storing various kinds of information, e.g., a RAM, a hard disk drive (HDD), an SSD, or a flash memory. The memory 22 stores a control program executed by the processor 20. The memory 22 serves as a log storage part 221, a model storage part 222, and a degradation degree storage part 223.

The log storage part 221 stores log data received by the communication part 21 from the vehicle 1 and the charge and discharge device 3 and use field information received together with the log data in association with each other.

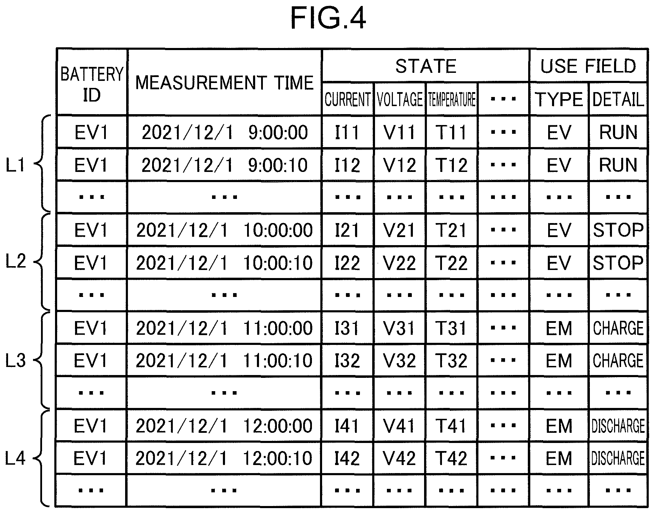

FIG. 4 is a table showing exemplary log data and use field information stored in the log storage part 221. FIG. 4 shows a reference sign L1, which denotes a group of records each having log data transmitted by an exemplary vehicle 1 provided with a battery 151 having a battery ID "EV1" at and after 9 o'clock on December 1, 2021 and use field information received by the communication part 21 together with the log data in association with each other. Hereinafter, the group of records is referred to as a record group L1. The use field information in the record group L1 has the vehicle use information "EV" as the type information and the running use information "Run" as the detail information.

FIG.4 shows a reference sign L2, which denotes a group of records each having log data transmitted by the exemplary vehicle 1 described above at and after 10 o'clock on December 1, 2021 and use field information received by the communication part 21 together with the log data in association with each other. Hereinafter, the group of records is referred to as a record group L2. The use field information in the record group L2 has the vehicle use information "EV" as the type information and the stopping use information "Stop" as the detail information.

FIG. 4 shows a reference sign L3, which denotes a group of records each having log data transmitted while the charge and discharge device 3 charges the battery 151 installed in the exemplary vehicle 1 described above at and after 11 o'clock on December 1, 2021 and use field information received by the communication part 21 together with the log data in association with each other. Hereinafter, the group of records is referred to as a record group L3. The use field information in the record group L3 has the external use information "EM" as the type information and the charging use information "Charge" as the detail information.

FIG. 4 shows a reference sign L4, which denotes a group of records each having log data transmitted while the charge and discharge device 3 causes discharge of power of the battery 151 installed in the exemplary vehicle 1 described above to the electric device 52 at and after 12 o'clock on December 1, 2021, and use field information received by the communication part 21 together with the log data in association with each other. Hereinafter, the group of records is referred to as a record group L4. The use field information in the record group L4 has the external use information "EM" as the type information and the discharging use information "Discharge" as the detail information.

The model storage part 222 prestores a degradation degree estimation model (trained model) that has learned a relationship between the state history of the battery 151 and the degradation degree of the battery 151. The degradation degree of the battery 151 indicates to what extent the battery 151 has degraded from an initial state. In other words, the degradation degree of the battery 151 indicates a variation from the initial value of the SOH of the battery 151. The degradation degree estimation model outputs, when receiving an input of log data indicative of a state history of the battery 151 from the initial state of the battery 151 to the present, a present degradation degree of the battery 151.

The degradation degree storage part 223 stores the degradation degree of the battery 151 estimated by the estimation part 203 using the degradation degree estimation model.

The processor 20 includes, e.g., a CPU. An execution of a control program stored in the memory 22 causes the processor 20 to function as a training part 200, an acquisition part 201, an extraction part 202, an estimation part 203, and an output part 204.

The training part 200 creates the degradation degree estimation model and stores the created degradation degree estimation model in the model storage part 222. A degradation degree estimation model is created by conducting a test in which a plurality of batteries 151 at the initial state installed in a plurality of vehicles 1 is used for a certain period. The certain period is, e.g., two or three months.

For example, the training part 200 acquires log data received by the communication part 21 from the vehicles 1 and the charge and discharge device 3 during the test. After completion of the test, the training part 200 acquires an SOH of the battery 151 of each of the vehicles 1 at the completion of the test stored in the non-volatile memory in the BMU 152 by communicating with each of the vehicles 1 through the communication part 21.

The training part 200 performs machine learning with a certain training algorithm for a relationship between the state history of each of the batteries 151 indicated by the acquired log data and a result obtained by reducing the SOH of each of the batteries 151 at the initial state by the SOH of each of the batteries 151 at the completion of the test. Thus, the training part 200 creates the degradation degree estimation model that outputs, when receiving input of log data indicative of the state history of the battery 151 from the initial state of the battery 151 to the present, the present degradation degree of the battery 151.

Similarly to the BMU 152, the training part 200 may estimate the present SOH of each of the batteries 151 at a certain time on the basis of the log data received by the communication part 21 during the test from each of the vehicles 1 and the charge and discharge device 3, and store the estimated SOH and a current date and time in the memory 22 in association with each other. In this configuration, the training part 200 acquires the SOH of each of the batteries 151 at the completion of the test from the memory 22, when creating a degradation degree estimation model.

The processor 20 may be configured not to function as the training part 200, and a degradation degree estimation model created by an information processing apparatus different from the server 2 may be prestored in the model storage part 222.

The acquisition part 201 acquires the log data and the use field information received by the communication part 21 from the vehicles 1 and the charge and discharge device 3 after the completion of the test, and stores the log data and the use field information in the log storage part 221 in association with each other.

The extraction part 202 extracts log data (hereinafter, specific log data) associated with each of the use fields from the log data stored in the log storage part 221. Specifically, the extraction part 202 extracts log data included in a group of records having the same type information and stored in the log storage part 221 as specific log data associated with a use field of the type indicated by the type information.

For example, in a case where the log storage part 221 stores the record groups L1 to L4 as shown in FIG. 4, the extraction part 202 extracts log data that is included in the record groups L1, L2 and has the vehicle use information "EV" as the type information as specific log data associated with the use in the vehicle 1 and the extraction part 202 extracts log data that is included in the record groups L3, L4 and has the external use information "EM" as the type information as specific log data associated with the use with the charge and discharge device 3.

The estimation part 203 estimates a degradation degree of the battery 151 caused by use of the battery 151 in each of the use fields associated with the specific log data extracted by the extraction part 202 by inputting the specific log data to the degradation degree estimation model stored in the model storage part 222. Hereinafter, a degradation degree of a battery 151 caused by use of the battery 151 in each of the use fields is referred to as a degradation degree of the battery 151 associated with each of the use fields.

For example, in a case where the log storage part 221 stores the record groups L1 to L4 as shown in FIG. 4 and the extraction part 202 extracts log data included in the record groups L1, L2 as specific log data associated with the use in the vehicle 1, the estimation part 203 inputs the specific log data to the degradation degree estimation model to thereby obtain a degradation degree of the battery 151 output by the degradation degree estimation model, which is the estimated degradation degree of the battery 151 caused by the use of the battery 151 in the vehicle 1. Hereinafter, a degradation degree of a battery 151 caused by use of the battery 151 in the vehicle 1 is referred to as a degradation degree of the battery 151 associated with vehicle use.

In a case where the extraction part 202 extracts log data included in the record groups L3, L4 as specific log data associated with the use with the charge and discharge device 3, the estimation part 203 inputs the specific log data to the degradation degree estimation model to thereby obtain a degradation degree of the battery 151 output by the degradation degree estimation model, which is the degradation degree of the battery 151 caused by the use of the battery 151 with the charge and discharge device 3. Hereinafter, a degradation degree of a battery 151 caused by use of the battery 151 with the charge and discharge device 3 is referred to as a degradation degree of the battery 151 associated with external use.

The output part 204 transmits (outputs) information indicative of each of the use fields of the battery 151 and the degradation degree of the battery 151 associated with each of the use fields to the user terminal 6 through the communication part 21.

For example, in a case where the estimation part 203 estimates the degradation degree of the battery 151 associated with the vehicle use and the degradation degree of the battery 151 associated with the external use as described in the cases above, the output part 204 transmits the vehicle use information "EV" and the degradation degree of the battery 151 associated with the vehicle use estimated by the estimation part 203 to the user terminal 6, and the output part 204 also transmits the external use information "EM" and the degradation degree of the battery 151 associated with the external use estimated by the estimation part 203 to the user terminal 6.

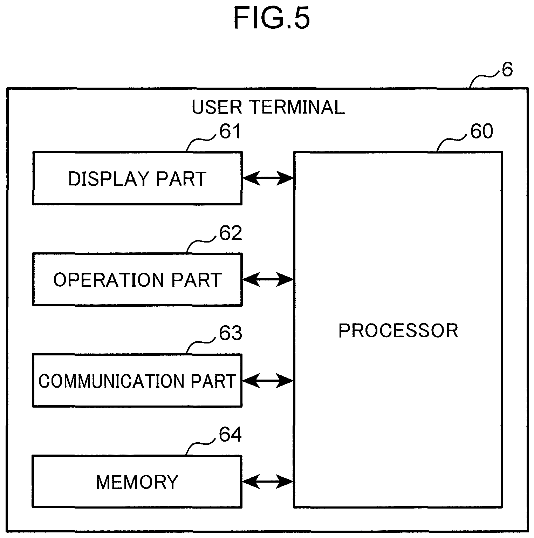

FIG. 5 is a diagram showing an exemplary configuration of the user terminal 6. As shown in FIG. 5, the user terminal 6 includes a display part 61, an operation part 62, a communication part 63, a memory 64, and a processor 60.

The display part 61 includes, e.g., a display device such as a liquid crystal display, and shows various kinds of information. The operation part 62 includes, e.g., a touchscreen device, and accepts various operations by the user. The communication part 63 is a communication interface circuit that transmits and receives various kinds of information to and from an external device such as the server 2 through the network 4. For example, the communication part 63 receives information indicative of each of the use fields of the battery 151 and the degradation degree of the battery 151 associated with each of the use fields from the server 2. The memory 64 is a storage device capable of storing various kinds of information, e.g., a RAM, a hard disk drive (HDD), an SSD, or a flash memory.

The processor 60 includes, e.g., a CPU, and controls the entirety of the user terminal 6. For example, in a case where the communication part 63 receives the information indicative of each of the use fields of the battery 151 and the degradation degree of the battery 151 associated with each of the use fields from the server 2, the processor 60 controls and causes the display part 61 to display a screen containing the information received by the communication part 63.

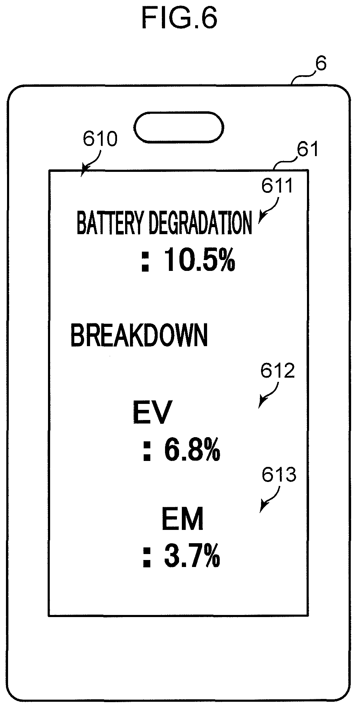

FIG. 6 is an illustration showing an exemplary degradation degree in each use field as an output. For example, the communication part 63 acquires the vehicle use information "EV" and a degradation degree "6.8%" of the battery 151 associated with the vehicle use from the server 2; further, the communication part 63 acquires the external use information "EM" and a degradation degree "3.7%" of the battery 151 associated with the external use from the server 2.

In this example, the processor 60 controls and causes the display part 61 to display a screen 610 as shown in FIG. 6. The screen 610 has information 612, 613 including each of the use fields of the battery 151 and the degradation degree of the battery 151 associated with each of the use fields in association with each other. The information 612 includes the vehicle use information "EV" and the degradation degree "6.8%" of the battery 151 associated with the vehicle use in association with each other. The information 613 includes the external use information "EM" and the degradation degree "3.7%" of the battery 151 associated with the external use in association with each other. The screen 610 has information 611 indicative of a total of the degradation degrees of the battery 151 associated with the respective use fields (in this example, 10.5% = 6.8% + 3.7%).

Next, a degradation degree estimation process executed in the server 2 will be described. The degradation degree estimation process is a process of estimating the degradation degree of the battery 151 associated with each of the use fields on the basis of the log data indicative of the state history of the battery 151.

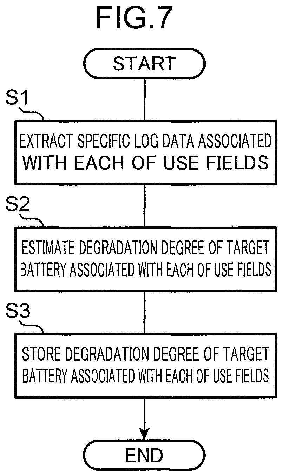

FIG. 7 is a flowchart showing steps of an exemplary degradation degree estimation process. The degradation degree estimation process is executed periodically, e.g., one time a day. The degradation degree estimation process is executed for each of the batteries 151 installed in the vehicles 1 under the information processing system 1000. Hereinafter, a battery 151 targeted for the degradation degree estimation process is referred to as a target battery 151.

First, in Step S1, the extraction part 202 extracts specific log data associated with each of the use fields from the log data that is stored in the log storage part 221 and indicative of the state history of the target battery 151.

Next, in Step S2, the estimation part 203 estimates a degradation degree of the target battery 151 associated with each of the use fields by inputting the specific log data extracted in Step S1 to the degradation degree estimation model stored in the model storage part 222.

Next, in Step S3, the estimation part 203 stores the degradation degree of the target battery 151 that is associated with each of the use fields and estimated in Step S2, and information indicative of each of the use fields in the degradation degree storage part 223 in association with each other. In a case where the degradation degree of the target battery 151 associated with each of the use fields has already been stored in the degradation degree storage part 223, the estimation part 203 updates the degradation degrees stored in the degradation degree storage part 223 with the latest degradation degrees estimated in Step S2.

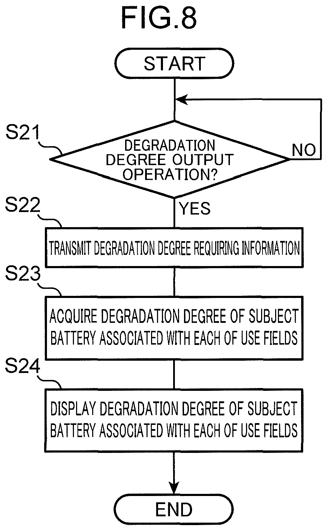

Next, a degradation degree output process executed in the user terminal 6 will be described. The degradation degree output process is a process of outputting the degradation degree of the battery 151 associated with each of the use fields. FIG. 8 is a flowchart showing steps of an exemplary degradation degree output process.

When the operation part 62 receives a certain operation (hereinafter, degradation degree output operation) by the user for executing the degradation degree output process in Step S21 (YES in Step S21), Step S22 is executed. The degradation degree output operation involves input of a battery ID of a battery 151 subject to the degradation degree output process. Hereinafter, the battery 151 assigned with the battery ID input in the degradation degree output operation, which is subject to the degradation degree output process, is referred to as a subject battery 151.

In Step S22, the processor 60 transmits, to the server 2 through the communication part 63, information (hereinafter, degradation degree requiring information) that requires a notification of the degradation degree of the subject battery 151 associated with each of the use fields. In the server 2, when the communication part 21 receives the degradation degree requiring information, the output part 204 sends back information that is stored in the degradation degree storage part 223 and indicative of each of the use fields of the subject battery 151 and the degradation degree of the subject battery 151 associated with each of the use fields to the user terminal 6 through the communication part 21.

Next, in Step S23, the processor 60 acquires the information that is received by the communication part 63 from the server 2 and indicative of each of the use fields of the subject battery 151 and the degradation degree of the subject battery 151 associated with each of the use fields.

Next, in Step S24, the processor 60 causes the display part 61 to display the screen 610 (FIG. 6) containing the information that is acquired in Step S23 and indicative of each of the use fields of the subject battery 151 and the degradation degree of the subject battery 151 associated with each of the use fields. Thus, the user having looked at the screen 610 can recognize respective degrees of degradation of the subject battery 151 in the use fields as well as the present degradation degree of the subject battery 151.

### Modifications

In the present disclosure, the following modifications may be implemented.
(1) The embodiment is described above with an example in which the user terminal 6 displays the information indicative of each of the use fields and the degradation degree of the battery 151 associated with each of the use fields. In this regard, the user terminal 6 may further display a breakdown of a degradation degree of the battery 151 associated with a use field. This configuration can be achieved, for example, as follows.

In Step S2 (FIG. 7), the estimation part 203 further classifies the specific log data extracted in Step S1 (FIG. 7) into one or more detail specific log data on the basis of the detail information of the use field information associated with the specific log data.

For example, the log storage part 221 stores the record groups L1 to L4 shown in FIG. 4; in Step S1 (FIG. 7), log data that is included in the record groups L1, L2 and has the vehicle use information "EV" as the type information is extracted as specific log data (hereinafter, first specific log data) associated with the use in the vehicle 1, and log data that is included in the record groups L3, L4 and has the external use information "EM" as the type information is extracted as specific log data (hereinafter, second specific log data) associated with the use with the charge and discharge device 3.

In this example, the estimation part 203 classifies the first specific log data into log data (hereinafter, first detail specific log data) that is included in the record group L1 and has the running use information "Run" as the detail information, and log data (hereinafter, second detail specific log data) that is included in the record group L2 and has the stopping use information "Stop" as the detail information.

Similarly, the estimation part 203 classifies the second specific log data into log data (hereinafter, third detail specific log data) that is included in the record group L3 and has the charging use information "Charge" as the detail information, and log data (hereinafter, fourth detail specific log data) that is included in the record group L4 and has the discharging use information "Discharge" as the detail information.

The estimation part 203 then inputs each of the detail specific log data to the degradation degree estimation model to obtain degradation degrees of the battery 151 output by the degradation degree estimation model, which are the estimated degradation degrees of the battery 151 associated with the respective detail specific log data.

In the example above, the estimation part 203 inputs the first detail specific log data to the degradation degree estimation model to obtain a degradation degree of the battery 151 output by the degradation degree estimation model, which is the estimated degradation degree of the battery 151 associated with the first detail specific log data; similarly, the estimation part 203 inputs the second, third, and fourth detail specific log data to the degradation degree estimation model to obtain degradation degrees of the battery 151 output by the degradation degree estimation model, which are the estimated degradation degrees of the battery 151 associated with the respective second, third, and fourth detail specific log data.

The estimation part 203 then calculates a ratio of the degradation degree of the battery 151 associated with each of the detail specific log data to the degradation degree of the battery 151 associated with the corresponding specific log data.

In the example above, the estimation part 203 calculates a ratio by dividing the degradation degree of the battery 151 associated with the first detail specific log data by the degradation degree of the battery 151 associated with the first specific log data. Similarly, the estimation part 203 calculates a ratio by dividing the degradation degree of the battery 151 associated with the second detail specific log data by the degradation degree of the battery 151 associated with the first specific log data.

Similarly, the estimation part 203 calculates a ratio by dividing the degradation degree of the battery 151 associated with the third detail specific log data by the degradation degree of the battery 151 associated with the second specific log data. Similarly, the estimation part 203 calculates a ratio by dividing the degradation degree of the battery 151 associated with the fourth detail specific log data by the degradation degree of the battery 151 associated with the second specific log data.

In Step S3 (FIG. 7), the estimation part 203 further stores the ratio of the degradation degree of the battery 151 associated with each of the detail specific log data to the degradation degree of the battery 151 associated with the corresponding specific log data, and the detail information associated with each of the detail specific log data, in the memory 22 in association with each other.

In the example above, the estimation part 203 stores the ratio calculated by using the first detail specific log data and the running use information "Run" as the detail information associated with the first detail specific log data, in the memory 22 in association with each other. Similarly, the estimation part 203 stores the ratios calculated by using the second, third, and fourth detail specific log data, and the stopping use information "Stop", the charging use information "Charge", and the discharging use information "Discharge" as the detail information associated with the second, third, and fourth detail specific log data, respectively, in the memory 22 in association with each other.

On the other hand, in the user terminal 6, the operation part 62 accepts a tap on information 612 or information 613 displayed on the screen 610 (FIG. 6) as an operation for executing a process of displaying a breakdown of the degradation degree indicated by the tapped information 612 or 613.

In this case, the processor 60 transmits to the server 2 type information (hereinafter, first specific type information) that is associated with the tapped information, and information (hereinafter, degradation degree breakdown requiring information) that requires a notification of the breakdown of the degradation degree.

In a case where the information 612 is tapped, the vehicle use information "EV" serves as the first specific type information. In a case where the information 613 is tapped, the external use information "EM" serves as the first specific type information. The operation for executing the process of displaying the breakdown of the degradation degree is not limited to tapping, and may be another operation, e.g., double tapping or continuously touching for a predetermined time or more.

In the server 2, when the communication part 21 receives the degradation degree breakdown requiring information, the output part 204 acquires the first specific type information received by the communication part 21 together with the degradation degree breakdown requiring information. The output part 204 sends back information that is stored in the memory 22 and indicative of the detail information associated with the first specific type information (hereinafter, specific detail information) and of the ratio associated with the specific detail information to the user terminal 6 through the communication part 21.

For example, in a case where the vehicle use information "EV" serves as the first specific type information, the specific detail information includes the running use information "Run" and the stopping use information "Stop". In a case where the external use information "EM" serves as the first specific type information, the specific detail information includes the charging use information "Charge" and the discharging use information "Discharge".

In the user terminal 6, the processor 60 acquires the information that is received by the communication part 63 from the server 2 and indicative of the specific detail information and the ratio associated with the specific detail information. The processor 60 then causes the display part 61 to display a screen containing the information indicative of the specific detail information and the ratio associated with the specific detail information.

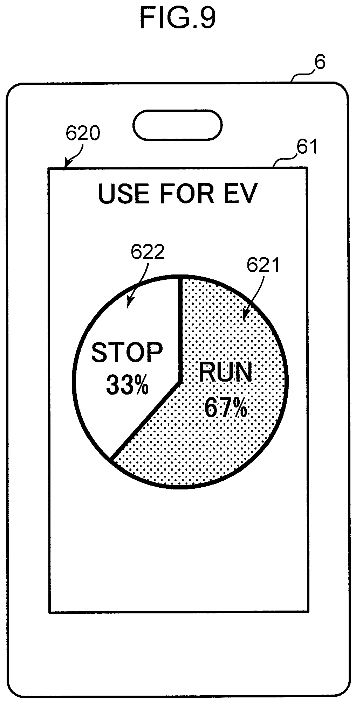

FIG. 9 is an illustration showing an exemplary breakdown of the degradation degree of the battery 151 associated with the use in the vehicle 1 as an output. A screen 620 shown in FIG. 9 is displayed in the case where the vehicle use information "EV" serves as the first specific type information. The screen 620 contains information 621 and information 622, each having specific detail information for the vehicle use information "EV" serving as the first specific type information and a ratio associated with the specific detail information in association with each other.

The information 621 has the running use information "Run" as the specific detail information for the vehicle use information "EV" serving as the first specific type information and the ratio "67%" associated with the specific detail information in association with each other. The information 622 has the stopping use information "Stop" as the specific detail information for the vehicle use information "EV" serving as the first specific type information and the ratio "33%" associated with the specific detail information in association with each other.

Thus, the user having looked at the screen 620 can recognize which of the uses of the battery 151 during running and stopping of the vehicle 1 has promoted the degradation of the battery 151 by comparing the information 621 and the information 622.

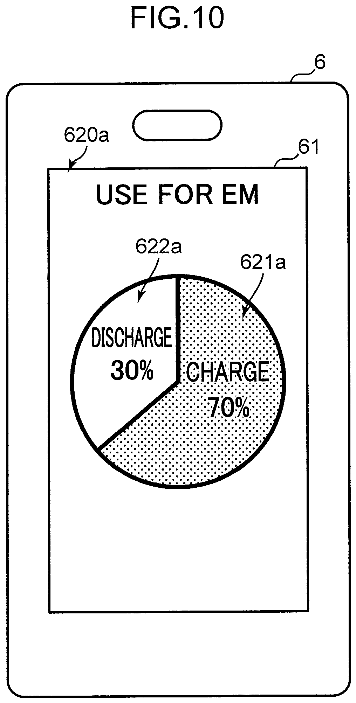

FIG. 10 is an illustration showing an exemplary breakdown of the degradation degree of the battery 151 associated with the use with the charge and discharge device 3 as an output. A screen 620a shown in FIG. 10 is displayed in the case where the external use information "EM" serves as the first specific type information. The screen 620a contains information 621a and information 622a, each having specific detail information for the external use information "EM" serving as the first specific type information and a ratio associated with the specific detail information in association with each other.

The information 621a has the charging use information "Charge" as the specific detail information for the external use information "EM" serving as the first specific type information and the ratio "70%" associated with the specific detail information in association with each other. The information 622a has the discharging use information "Discharge" as the specific detail information for the external use information "EM" serving as the first specific type information and the ratio "30%" associated with the specific detail information in association with each other.

Thus, the user having looked at the screen 620a can recognize which of the uses of the battery 151 during charge and discharge with the charge and discharge device 3 has promoted the degradation of the battery 151 by comparing the information 621a and the information 622a.

(2) The server 2 may further acquire information (hereinafter, first information) on the state of the battery 151 during discharge and information (hereinafter, second information) on the state of the battery 151 during charge from the specific log data associated with each of the use fields, and the user terminal 6 may further display the first information and the second information. This configuration can be achieved, for example, as follows.

In Step S2 (FIG. 7), the estimation part 203 further classifies the specific log data extracted in Step S1 (FIG. 7) into specific log data (hereinafter, discharge log data) indicative of discharge and specific log data (hereinafter, charge log data) indicative of charge.

For example, similarly to the example above, in Step S1 (FIG. 7), log data that is included in the record groups L1, L2 (FIG. 4) and has the vehicle use information "EV" as the type information is extracted as the first specific log data associated with the use in the vehicle 1; and log data that is included in the record groups L3, L4 (FIG. 4) and has the external use information "EM" as the type information is extracted as the second specific log data associated with the use with the charge and discharge device 3.

In this example, the estimation part 203 refers to a current value of the battery 151 indicated by the state information included in the first specific log data, and classifies log data indicative of a current value during discharge (e.g., negative value) as the discharge log data, and log data indicative of a current value during charge (e.g., positive value) as the charge log data.

On the other hand, the estimation part 203 classifies, among the second specific log data, log data that is included in the record group L3 and has the charging use information "Charge" as the detail information as the charge log data, and log data that is included in the record group L4 and has the discharging use information "Discharge" as the detail information as the discharge log data.

The estimation part 203 then refers to a measurement time and state information included in the discharge log data classified from each of the specific log data, and generates, as first information, a histogram (hereinafter, discharge histogram) indicative of a relationship between a discharge rate indicative of a discharge amount per a unit time from the battery 151 and a total time during which the battery 151 is discharged at the discharge rate. The discharge amount per the unit time from the battery 151 is represented by a discharge current amount per the unit time from the battery 151.

The estimation part 203 refers to a measurement time and state information included in the charge log data classified from each of the specific log data, and generates, as second information, a histogram (hereinafter, charge histogram) indicative of a relationship between a charge rate indicative of a charge amount per a unit time for the battery 151 and a total time during which the battery 151 is charged at the charge rate. The charge amount per the unit time for the battery 151 is represented by a charge current amount per the unit time to the battery 151.

In the example above, the estimation part 203 refers to the measurement time and the state information included in the discharge log data classified from the first specific log data, and generates a discharge histogram as first information associated with the discharge log data (hereinafter, first-first information). Similarly, the estimation part 203 refers to the measurement time and the state information included in the discharge log data classified from the second specific log data, and generates a discharge histogram as first information associated with the discharge log data (hereinafter, second-first information).

The estimation part 203 refers to the measurement time and the state information included in the charge log data classified from the first specific log data, and generates a charge histogram as second information associated with the charge log data (hereinafter, first-second information). Similarly, the estimation part 203 refers to the measurement time and the state information included in the charge log data classified from the second specific log data, and generates a charge histogram as second information associated with the charge log data (hereinafter, second-second information).

In Step S3 (FIG. 7), the estimation part 203 further stores the first information associated with the discharge log data classified from each of the specific log data and the second information associated with the charge log data classified from each of the specific log data in the memory 22.

On the other hand, in the user terminal 6, the operation part 62 accepts a double tap on the information 612 or the information 613 displayed on the screen 610 (FIG. 6) as an operation for executing a process of displaying first information and second information associated with a use field of the type indicated by the double-tapped information 612 or 613.

In this case, the processor 60 transmits to the server 2 type information (hereinafter, second specific type information) that is associated with the double-tapped information and information (hereinafter, charge and discharge detail requiring information) that requires a notification of the first information and the second information.

In a case where the information 612 is double-tapped, the vehicle use information "EV" serves as the second specific type information. In a case where the information 613 is double-tapped, the external use information "EM" serves as the second specific type information. The operation for executing the process of displaying the first information and the second information is not limited to double-tapping, and may be another operation, e.g., tapping or continuously touching for a predetermined time or more.

In the server 2, when the communication part 21 receives the charge and discharge detail requiring information, the output part 204 acquires the second specific type information received by the communication part 21 together with the charge and discharge detail requiring information. The output part 204 sends back first information and second information generated from specific log data associated with the second specific type information and stored in the memory 22 to the user terminal 6 through the communication part 21.

In the example above, the first-first information and the first-second information stored in the memory 22 are sent back in the case where the vehicle use information "EV" serves as the second specific type information. On the other hand, the second-first information and the second-second information stored in the memory 22 are sent back in the case where the external use information "EM" serves as the second specific type information.

In the user terminal 6, the processor 60 acquires the first information and the second information received by the communication part 63 from the server 2. The processor 60 then causes the display part 61 to display a screen containing the first information and the second information.

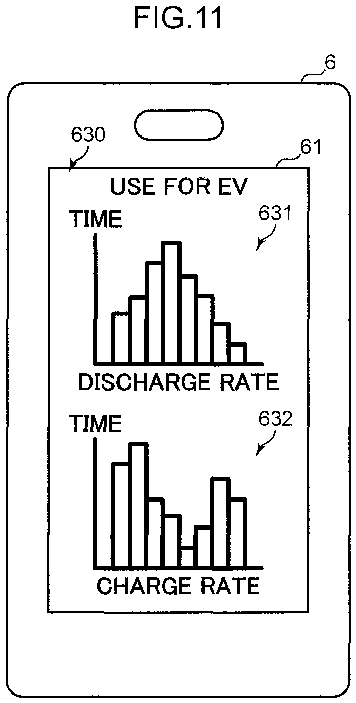

FIG. 11 is an illustration showing exemplary information on the states of the battery 151 during discharge and charge as an output. A screen 630 shown in FIG. 11 is displayed in the case where the vehicle use information "EV" serves as the second specific type information. The screen 630 contains the first-first information 631 and the first-second information 632 generated from specific log data associated with the vehicle use information "EV". In the case where the external use information "EM" serves as the second specific type information, a screen similar to the screen 630, which contains the second-first information and the second-second information, is displayed.

Thus, the user having referred to the first information and the second information can recognize the states of the battery 151 during discharge and charge in use of the battery 151 in each of the use fields.

The modification may be simplified such that the estimation part 203 generates at least one of the first information and the second information and the user terminal 6 displays the at least one information. The first information is not limited to the discharge histogram, and may be other information on the state of the battery 151 during discharge. Similarly, the second information is not limited to the charge histogram, and may be other information on the state of the battery 151 during charge.

(3) The server 2 may further generate a histogram (hereinafter, DOD histogram) indicative of a relationship between a depth of discharge (DOD) in a discharge of the battery 151 immediately before a start of a charge of the battery 151 and a number of times of chargings of the battery 151 having the depth of discharge on the basis of the specific log data associated with each of the use fields, and the user terminal 6 may further display the DOD histogram. This configuration can be achieved, for example, as follows.

In Step S2 (FIG. 7), the estimation part 203 further acquires the charge log data from the specific log data extracted in Step S1 (FIG. 7).

For example, similarly to the example above, in Step S1 (FIG. 7), log data that is included in the record groups L1, L2 (FIG. 4) and has the vehicle use information "EV" as the type information is extracted as the first specific log data associated with the use in the vehicle 1, and log data that is included in the record groups L3, L4 (FIG. 4) and has the external use information "EM" as the type information is extracted as the second specific log data associated with the use with the charge and discharge device 3.

In this example, the estimation part 203 refers to the current value of the battery 151 indicated by the state information included in the first specific log data, and acquires log data indicative of a current value during charge (e.g. positive value) as the charge log data. On the other hand, the estimation part 203 acquires, from the second specific log data, log data that is included in the record group L3 and has the charging use information "Charge" as the detail information as the charge log data.

The estimation part 203 then refers to each of the specific log data, and generates a DOD histogram indicative of a relationship between: a depth of discharge in a discharge of the battery 151 immediately before a start of a charge of the battery 151, the depth of discharge being indicated by the charge log data acquired from each of the specific data; and a number of times of chargings of the battery 151 having the depth of discharge.

In Step S3 (FIG. 7), the estimation part 203 further stores the DOD histogram generated on the basis of each of the specific log data in the memory 22.

On the other hand, in the user terminal 6, the operation part 62 accepts a continuous touch for a predetermined time or more on the information 612 or the information 613 displayed on the screen 610 (FIG. 6) as an operation for executing a process of displaying a DOD histogram associated with a use field of the type indicated by the touched information 612 or 613.

In this case, the processor 60 transmits to the server 2 type information (hereinafter, third specific type information) that is associated with the information continuously touched for the predetermined time or more and information (hereinafter, DOD histogram requiring information) that requires a notification of the DOD histogram.

In a case where the information 612 is continuously touched for the predetermined time or more, the vehicle use information "EV" serves as the third specific type information. In a case where the information 613 is continuously touched for the predetermined time or more, the external use information "EM" serves as the third specific type information. The operation for executing the process of displaying the DOD histogram is not limited to continuously touching for the predetermined time or more, and may be another operation, e.g., tapping or double-tapping.

In the server 2, when the communication part 21 receives the DOD histogram requiring information, the output part 204 acquires the third specific type information received by the communication part 21 together with the DOD histogram requiring information. The output part 204 sends back the DOD histogram generated by using the specific log data associated with the third specific type information and stored in the memory 22 to the user terminal 6 through the communication part 21.

In the user terminal 6, the processor 60 causes the display part 61 to display a screen containing the DOD histogram received by the communication part 63 from the server 2.

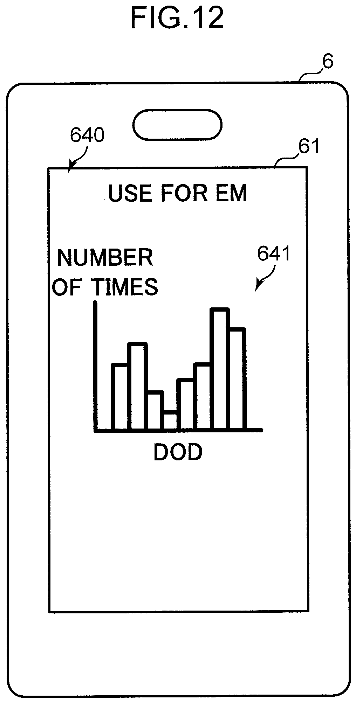

FIG. 12 is an illustration showing an exemplary DOD histogram 641 as an output. A screen 640 shown in FIG. 12 is displayed in a case where the external use information "EM" serves as the third specific type information. The screen 640 contains the DOD histogram 641 generated by using specific log data associated with the external use information "EM". In a case where the vehicle use information "EV" serves as the third specific type information, a screen similar to the screen 640, which contains a DOD histogram generated by using specific log data associated with the vehicle use information "EV", is displayed.

Thus, the user having referred to the DOD histogram 641 can recognize a relationship in the use of the battery 151 in each of the use fields between a depth of discharge in a discharge of the battery 151 immediately before a start of a charge of the battery 151 and a number of times of chargings of the battery 151 having the depth of discharge.

(4) The embodiment and the modifications above are described on the basis of an example in which the estimation part 203 estimates a degradation degree of the target battery 151 associated with each of the use fields in Step S2 (FIG. 7) by inputting the specific log data extracted in Step S1 (FIG. 7) to the degradation degree estimation model stored in the model storage part 222. The way the estimation part 203 estimates the degradation degree of the target battery 151 associated with each of the use fields by using the specific log data extracted in Step S1 (FIG. 7) is not limited to this.

For example, an experiment for acquiring a degradation characteristic of a battery 151 in repeated use of the battery 151 under each of a plurality of use conditions may be performed, and each of the use conditions and the degradation characteristic of the battery 151 in repeated use of the battery 151 under each of the use conditions may be prestored in the memory 22 in association with each other. The use condition includes, e.g., a current, a voltage, and a temperature of the battery 151 in use. The degradation characteristic of the battery 151 is a temporal transition of the SOH of the battery 151.

In Step S2 (FIG. 7), the estimation part 203 may then refer to each state information piece included in the specific log data extracted in Step S1 (FIG. 7), and acquire from the memory 22 a degradation characteristic (hereinafter, degradation characteristic corresponding to a state information piece) that is associated with a use condition corresponding to each of the state information pieces.

A use condition corresponding to one state information piece refers to a use condition indicative of a current, a voltage, and a temperature respectively different by a predetermined value or less from a current, a voltage, and a temperature indicated by the one state information piece. In a case where a proper use condition is not stored in the memory 22, the estimation part 203 may select a use condition corresponding to a state information piece according to a predetermined rule from the use conditions stored in the memory 22. For example, the estimation part 203 may select, from the use conditions stored in the memory 22, a use condition indicative of such a current, a voltage, and a temperature as to minimize a sum of respective differences from the current, the voltage, and the temperature indicated by the one state information piece as the use condition corresponding to the one state information piece.

The estimation part 203 may then calculate the SOH of the battery 151 at a measurement time corresponding to each of the state information pieces sequentially by using the degradation characteristic corresponding to each of the state information pieces, and calculate a present degradation degree of the battery 151 using the calculated SOH. A measurement time corresponding to one state information piece refers to a measurement time associated with the one state information piece in the specific log data.

(5) The embodiment and the modifications above are described on the basis of an exemplary case where the chargeable and dischargeable battery under the information processing system 1000 is the battery 151 installed in the vehicle 1. However, the chargeable and dischargeable battery under the information processing system 1000 is not limited to this, and may be another chargeable and dischargeable battery used for a plurality of electric devices, e.g., a battery installed in the electric mobile body described above or a battery charged with power generated by a solar power generator provided to a house.

In this case, the use field information has, e.g., information indicative of types (e.g., an air conditioner) of the electric devices using the battery as the type information and information indicative of places (e.g., a living room) where the electric devices are disposed as the detail information.

### Industrial Applicability

The technique of the present disclosure enables recognition of a degradation degree of a chargeable and dischargeable battery used in a plurality of use fields with respect to each of the use fields, and thus is useful for a guarantee about the battery based on a use field.

## Claims

1. An information processing method for outputting a degradation degree of a chargeable and dischargeable battery, by a computer, comprising:
acquiring log data indicative of a state history of the battery and information indicative of a plurality of use fields of the battery associated with the log data;
extracting specific log data associated with each of the use fields from the log data;
estimating a degradation degree of the battery caused by use of the battery in each of the use fields on the basis of the specific log data associated with each of the use fields; and
outputting each of the use fields and the degradation degree of the battery associated with each of the use fields.

2. The information processing method according to claim 1, wherein, in the estimation, the degradation degree of the battery caused by the use of the battery in each of the use fields is estimated by inputting the specific log data to a trained model that has learned a relationship between the state history of the battery and the degradation degree of the battery.

3. The information processing method according to claim 1, wherein
the battery is installed in a vehicle and is chargeable and dischargeable by a charge and discharge device outside the vehicle, and
the use fields include use in the vehicle and use with the charge and discharge device.

4. The information processing method according to claim 3, wherein
the use in the vehicle is classified into use during running of the vehicle and use during stopping of the vehicle, the information processing method further comprising:
outputting respective ratios of degradation degrees of the battery associated with the use during running of the vehicle and the use during stopping of the vehicle to the degradation degree of the battery associated with the use in the vehicle.

5. The information processing method according to claim 3, wherein
the use with the charge and discharge device is classified into charging use and discharging use, the information processing method further comprising:
outputting respective ratios of degradation degrees of the battery associated with the charging use and the discharging use to the degradation degree of the battery associated with the use with the charge and discharge device.

6. The information processing method according to any one of claims 3 to 5, further comprising:
acquiring at least one of first information on a state of the battery during discharge and second information on a state of the battery during charge from the specific log data; and
outputting the at least one information.

7. The information processing method according to claim 6, wherein
the first information includes a histogram indicative of a relationship between a discharge rate indicative of a discharge amount per a unit time from the battery and a total time during which the battery is discharged at the discharge rate, and
the second information includes a histogram indicative of a relationship between a charge rate indicative of a charge amount per a unit time for the battery and a total time during which the battery is charged at the charge rate.

8. The information processing method according to claim 3, further comprising:
outputting a histogram indicative of a relationship between a depth of discharge in a discharge of the battery immediately before a start of a charge of the battery and a number of times of chargings of the battery having the depth of discharge on the basis of the specific log data.

9. The information processing method according to claim 1, wherein the degradation degree of the battery is a variation from an initial value of an SOH of the battery.

10. An information processing apparatus for outputting a degradation degree of a chargeable and dischargeable battery comprising:
an acquisition part for acquiring log data indicative of a state history of the battery and information indicative of a plurality of use fields of the battery associated with the log data;
an extraction part for extracting specific log data associated with each of the use fields from the log data;
an estimation part for estimating a degradation degree of the battery caused by use of the battery in each of the use fields on the basis of the specific log data associated with each of the use fields; and
an output part for outputting each of the use fields and the degradation degree of the battery associated with each of the use fields.

11. control program for an information processing apparatus for outputting a degradation degree of a chargeable and dischargeable battery, the control program causing a computer included in the information processing apparatus to serve as:
an acquisition part for acquiring log data indicative of a state history of the battery and information indicative of a plurality of use fields of the battery associated with the log data;
an extraction part for extracting specific log data associated with each of the use fields from the log data;
an estimation part for estimating a degradation degree of the battery caused by use of the battery in each of the use fields on the basis of the specific log data associated with each of the use fields; and
an output part for outputting each of the use fields and the degradation degree of the battery associated with each of the use fields.
